(19) Europäisches Patentamt / European Patent Office / Office européen des brevets

(11) **EP 3 216 082 B1**

(12) **EUROPEAN PATENT SPECIFICATION**

(45) Date of publication and mention
of the grant of the patent:
**16.09.2020 Bulletin 2020/38**

(21) Application number: **15816519.1**

(22) Date of filing: **07.11.2015**

(51) Int Cl.:
*H01Q 1/36* *(2006.01)*　　*H02K 3/04* *(2006.01)*
*H02K 3/26* *(2006.01)*　　*H04B 5/00* *(2006.01)*
*G06K 19/077* *(2006.01)*　　*H01F 27/24* *(2006.01)*
*H01F 27/26* *(2006.01)*　　*H01F 27/28* *(2006.01)*
*H01F 27/30* *(2006.01)*　　*H01F 38/14* *(2006.01)*
*H01Q 1/22* *(2006.01)*　　*H01Q 1/38* *(2006.01)*
*H01F 27/00* *(2006.01)*　　*H01F 27/25* *(2006.01)*
*H01Q 7/06* *(2006.01)*　　*H01Q 7/08* *(2006.01)*
*H01F 5/06* *(2006.01)*　　*H01F 17/08* *(2006.01)*
*H01F 27/32* *(2006.01)*

(86) International application number:
**PCT/IB2015/058607**

(87) International publication number:
**WO 2016/071885 (12.05.2016 Gazette 2016/19)**

(54) **NON-STATIONARY MAGNETIC FIELD EMITTER**

NICHTSTATIONÄRER MAGNETFELDEMITTER

ÉMETTEUR DE CHAMP MAGNÉTIQUE NON STATIONNAIRE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **08.11.2014 SK 500672014**

(43) Date of publication of application:
**13.09.2017 Bulletin 2017/37**

(73) Proprietor: **SMK Corporation
Shinagawa-ku
Tokyo 142-8511 (JP)**

(72) Inventor: **FLOREK, Miroslav
821 01 Bratislava (SK)**

(74) Representative: **Porubcan, Róbert
Puskinova 19
900 28 Ivanka pri Dunaji (SK)**

(56) References cited:
**EP-A1- 1 460 715**　　　**EP-A1- 2 453 523**
**WO-A1-2014/076669**　　**JP-A- 2004 200 829**
**US-A1- 2011 241 957**

**Description**

**Field of technology**

The invention concerns the non-stationary magnetic field emitter which operates as a miniature antenna on a flat carrier with little available build height, especially on the surface of the removable card such as microSD card or SIM, mini-SIM, micro-SIM or nano-SIM card. The emitter can be used directly on the chip, on the printed circuit board (PCB), and it can be used additionally for creation of the contactless NFC/RFID communication channel in the electronic device even in case when the space with the antenna is shielded by the environment, for example by the metal cover of the host device.

**State of the art**

Flat antennas in shape of the conductive loops are usually used for NFC/RFID, whereby in the case the carrier is small all available surface is used for the placing of the conductor. When placing the NFC antenna on the relatively small surfaces, the antenna has a form of the inscribed rectangular spiral winding with rounded corners which basically copies the outer shape of the available surface. This arrangement produced a typical shape of the NFC antennas. Antennas for NFC/RFID transfers are in principle flat, with the winding of the loops running on the edges of the available surface, for example according to DE102008005795, KR100693204, WO2010143849, JP2004005494, JP2006304184, JP2005033461, and JP2010051012.

The earlier patent publications of the Logomotion describe the arrangement of the antenna and individual layers of the removable memory card in order to set the emitting and receiving characteristics of the antenna in such a way that the reliable communication channel can be created even for various shielded slots of the card. Defined in this way, the technical task has led to realization of multiple technical solutions, which however reached satisfactory results only for some of the mobile phones; the course of invention subsequently took the direction of production of larger, sufficient antennas on the body of the mobile phone outside the shielded areas. These sufficient antennas (CN201590480 U), for example in the form of a sticker, can be contactlessly connected to the basic antenna on the card; however, such arrangement is not universal enough and the application is annoyingly complicated in the hands of the common user.

US 2011/241957 A1 (OHARA MASAHIRO [JP]) 6 October 2011 (2011-10-06) discloses an antenna device with core portion 11 of nickel ferrite magnetic material, wherein first winding layer 54 is wound on the core portion 11, winding portion 52A and inductance adjuster portion 56 are connected in series. The inductance adjuster portion 56 consists of one turn of conductive wire 131, and has pitch P56 which is larger than pitch P52A of winding portion 52A.

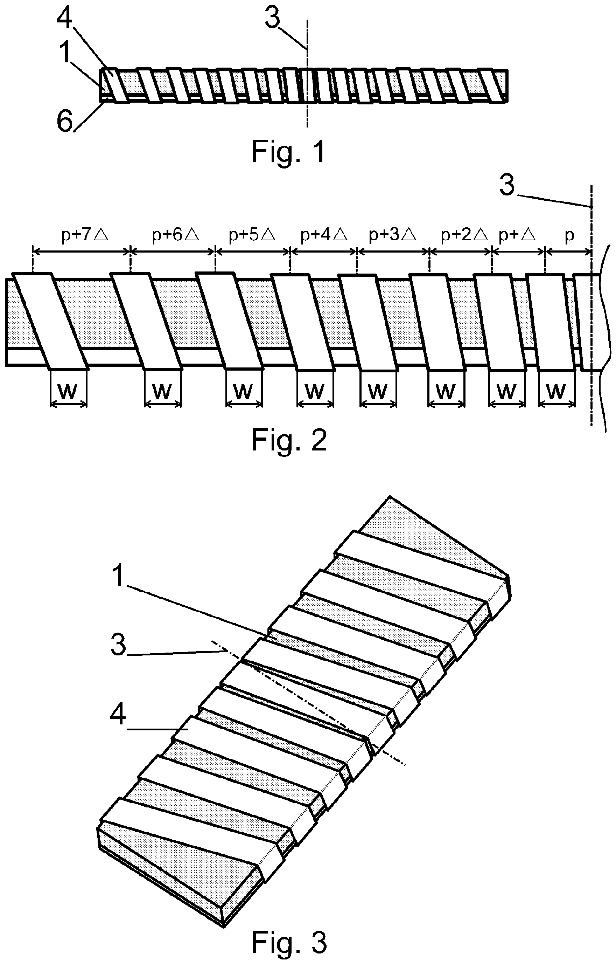

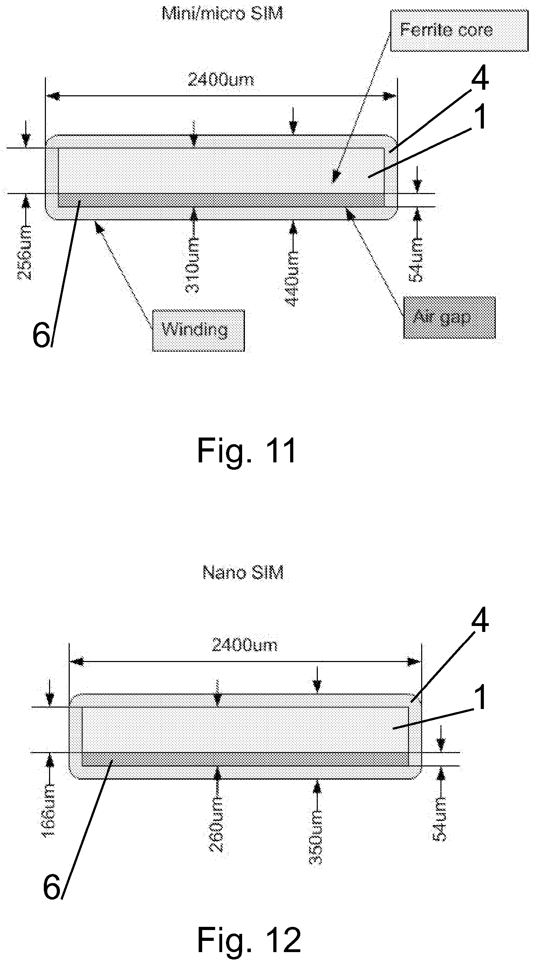

Basic theoretical and expert publications express an opinion that with small thickness and available surface the RFID or NFC antenna should be produced as flat antenna, for example according to RFID HANDBOOK, Klaus Finkenzeller, 2010, pursuant to figures 2.11, 2.15, 12.7, 12.9, 12.11, 12.13. According to the same source (part 4.1.1.2 Optimal Antenna Diameter / Physical Principles of RFID Systems) it is most optimal if the semi-diameter of the emitting antenna corresponds to the square root of the required reach of the antenna.

The application of the knowledge about the existing NFC antennas to the field with little available space does not bring desired results, because with miniaturization beyond certain level the characteristics of the resulting antenna do not change linearly. The decisive benefit for the miniaturization of the NFC/RFID antenna, suitable for the placing on the microSD card, was brought by publication WO/2014/076669 which allows the creation of the contactless communication channel even with small and shielded antenna. This publication discloses the principles of a construction with the ferrite core which has a circular, rectangular or similar cross-section. However, practice has shown that further diminishing of the thickness of the antenna is needed in order for placing it in the layer above the existing elements, for example above the chip.

| | Height | Width | Depth | Front view | Standard reference |
|---|---|---|---|---|---|
| **Mini-SIM** | 25 mm | 15 mm | 0.76 mm | | ISO/IEC 7810:2003, ID-000 |
| **Micro-SIM** | 15 mm | 12 mm | 0.76 mm | | ETSI TS 102 221 V9.0.0, Mini-UICC |

(continued)

| | Height | Width | Depth | Front view | Standard reference |
|---|---|---|---|---|---|
| **Nano-SIM** | 12.3 mm | 8.8 mm | 0.67 mm | | ETSI TS 102221 V11.0.0 |

Such solution is needed and not known, which will secure the high conductivity of the signal emitted from the PCB board of the electronic device, from the SIM card of any dimensions, or from the removable card with a very small available space.

<u>Subject matter of the invention</u>

The invention is defined by the independent claim. Preferred embodiments of the invention are stipulated in the dependent claims. While several embodiments and/or examples have been disclosed in this description, the subject-matter for which protection is sought is strictly and solely limited to those embodiments and/or examples encompassed by the scope of the appended claims. Embodiments and/or examples mentioned in the description that do not fall under the scope of the claims are useful for understanding the invention.

It has been found out during the inventing of this invention that the increasing pitch of the threads, that is, the increasing lead of the thread towards the end of the core causes the saturation of the magnetic core from the middle to linearly diminish towards its edges, which lowers the hysteresis losses caused by the high intensity of the magnetic field. With constant increase the intensity of the field on its end diminishes hyperbolically, which means that it is initially very high and practically constant alongside the whole length with the exception of the ends where it sharply drops towards zero; therefore, the hysteresis losses are higher compared with the solution with widening threads according to this invention. It is also crucial that the width of a thread is at least three times its height, that is, it is crucial that the thread is flat.

The increase of the lead will be mainly linear according to this relationship:

$$p_{n+1}=p_n+\Delta,$$

where $\Delta$ is the increment of the lead, p is lead, pitch of the thread, n is the order of the thread counting from the middle towards the end. The addition of the lead will range from 10 to 30 % of the width of the conductor of the thread in the middle zone; preferably it will be 20%.

Apart from the linearly increasing pitch of the thread it is possible to increase the pitch according to another curve, for example in such a way that $\Delta$ increments of the lead increases for any next thread n+1.

The invention can be realized by multiple technological methods. The conductor can be flat and wound in such a way that the angle of the lead gradually increases towards the end of the core. In case of flat conductors the changing angle of the lead leads to deformations, though, which increases the risk of severing of the thin flat conductor. One solution is an arrangement where the flat conductor in the unwound state is a strip with a gradually cranking, bending course. The lines in which the direction of the strip changes are set by the dimension of the respective edge of the core around which the strip of the conductor is bent during winding.

The other method of creation of the increasing pitch of the thread is application of the conductive layer without the mechanical winding, for example by vacuum steaming, printing, and so on. This allows creating a conductive layer of the thread where the pitch or lead of the thread gradually increases and the width of the conductor increases correspondingly; the gaps between adjacent threads can then be constant.

Another method which allows the change of the lead of the thread produced from the flat conductor is the composition of the flat conductor from the independent parts from above and from below. The division of the conductor to multiple parts allows the production of the threads with the changing angle of the winding without deformations leading to the severing of the conductor. From the point of view of effectiveness of the production it is possible to produce the threads from the pairs of strips. In order to achieve a reliable envelopment of the core by the conductor which is not one solid whole for a thread, such arrangement has been invented where the conductor is produced as a bi-metal strip with two layers of the material with different thermal expansion. The strip of the conductor is in cooled state developed through three sides of the cross-section of the core; preferably it will have short folds on the fourth side of the cross-section. After warming the conductor to the common temperature, the shear stresses appear between both layers in the conductor, forcing the strip to deform towards the envelopment of the core. This long-term stress stabilizes the position of the strip of the conductor.

In a preferable arrangement the first two or multiple threads are placed close to each other in the middle zone of the core; the gaps between the threads can increase towards the end of the core with the width of one thread of the conductor remaining constant. According to the used method of the winding it is possible to produce an increasing width of the conductor which then has a uniform, usually very small isolation gap between the conductors of the adjacent threads. For example, in case of application of the conductive layer onto the core or in case of the usage of the cranked strip the threads can be placed adjacently to each other without the increasing gaps. In case of increasing gaps the emitter can be equipped by a metal cover alongside the core. The metal cover can have a form of the thin iron or copper foil. In case of production of the threads by use of a bi-metal realization of the conductors the cover in form of a foil can serve during the production as a carrier of the strips of the conductor, too; these strips can be stuck to the cover in the required pitch.

The effective width w of one thread in the middle zone is in the preferable arrangement in the range $r_e/2 < w < 1,5 r_e$; where $r_e$ is the equivalent radius. With rectangular cross-section with the dimensions of sides "a", "b" without the rounding of the edges the equivalent radius is $r_e = \sqrt{(a.b/\pi)}$. The equivalent radius expresses the radius of the circular core which has an identical surface of the cross-section as rectangular cross-section with sides a, b.

It also has been invented that in the preferable arrangement the flat conductor can be substituted by the system of at least three conductors wound next to each other, which however further form only a single thread. These conductors are electrically connected. If we want to substitute flat conductor with the original ratio of the width and height 1:4, we use four conductors of the uniformly circular cross-section as substitutes for this conductor, we wind them next to each other as if this was a three-degree thread. If we are going to substitute the flat conductor with original 1:8 (height: width) cross-section, we use 8 conductors of circular cross-section placed next to each other, which in mechanical understanding constitute an eight-degree thread. The conductors in one multi-degree thread would not have to be isolated, because these conductors will be electrically connected at the ends of the windings; but for the purposes of technological simplicity a similar, isolated conductor can be used for each conductor of a given thread. In another arrangement only the conductors of the single thread which are on the edge are to be electrically isolated; the conductors located inside do not have to be isolated.

The examples of the dimensions of the antenna capable of emitting from the shielded slot of the SIM card in the phone are following:

| Size | Total thickness | Ferrite core | Air gap | Width | Length |
|------|-----------------|--------------|---------|-------|--------|
| **Mini/Micro SIM** | 440 $\mu$m | 265 $\mu$m | 54 $\mu$m | 2400 $\mu$m | 8-10 mm |
| **Nino SIM** | 350 $\mu$m | 166 $\mu$m | 54 $\mu$m | 2400 $\mu$m | 8-10 mm |

The dimensional ratios described in this invention have inner connections which are related to the creation of the magnetic field. The ratios of the width of the conductor and the equivalent radius of the core are related to the theory of Helmholtz coils, which has led to excellent transmitting parameters in the arrangement according to this invention; this has been confirmed by measurings, too.

Multiple possibilities of preserving the crucial rule of increasing lead of the threads according to this invention have been invented for multiplied conductor. One possibility is that the multiplied conductor is wound with the increasing pitch of the threads, whereby there is no gap between the conductors of one thread; the gap increases only between the outer conductors of the adjacent threads. This version imitates the flat conductor with constant width. Another possibility is characterized by the fact that with the increasing pitch of the threads the conductors of one thread start to diverge from each other and the increasing gap from the first possibility is - so to say - distributed between every conductor. In such case the gap between the conductors of the thread $m = n \Delta / x$, where x is the number of the conductors for one thread and $n \Delta$ is the increment of the lead for a given thread.

Another possibility is the reeling of another conductor up to certain number of the thread, that is, the number of the conductors of one thread gradually increases; the conductors in such case are still close to each other, but the pitch of the threads increases.

It has appeared in the process of inventing of this emitter that precisely the use of the flat thread in form of a multi-degree circular conductor and the increasing pitch manifest themselves in synergetic co-operation of multiple physical laws. Within the described range of the dimension ratios and in the vicinity of that interval there is a directional co-action of the magnetic field from the individual parts of the conductor and from the individual threads without the appearance of undesired eddy currents, whereby the magnetic field in the core intensifies and, and the same time, does not flow out along the winding outside the end fronts of the core.

The core is oblong both in the longitudal and transverse cross-section. The core can be curved, but best results are achieved with direct core rods, where the field lines of the magnetic field enclose outside the emitter in the longest possible path and there is therefore the tendency to flow of the shielded space. The core's ferrite should have the relative permeability set in such a way that the inductance of the emitter is ranging from 600 nH to 1200 nH, preferably close to 1000 nH, and in $20<Q<30$ quality. When taking this criterion into account, the ferrite core can have permeability ranging from 30 to 300. The permeability of the core will be set according to technological possibilities of the maximum allowed magnetic saturation and the dimensional conditions of the core's cross-section. The term "ferrite" hereby denotes any material which increases the features of the magnetic field.

The effort to achieve homogenous magnetic field with high intensity, which will emit to the distant ends of the core, is accompanied by contradictory requirements. It is appropriate to use the smallest number of threads, but with diminishing number of the threads the current load necessary for the emission of the signal increases; the size of the current itself is, however, limited by the elements of the host device. The use of the flat conductor or the use of multi-degree conductors of one thread led in parallel adjacently to each other significantly remedies this conflict of requirements.

It has proved especially preferable in this regard to use multi-degree conductors of one thread led in parallel adjacently to each other. Such produced thread has a larger surface than monolithic flat conductor of identical width or as a conductor with identical surface of the cross-section. The larger surface or larger circumference of the cross-section, respectively, contributes to the better conducting of the electricity thanks to skin effect. This effect synergically contributes to the effective result, mainly during current flow which changes frequencies in magnitudes of MHz.

The emitter with miniature dimensions can be placed on the PCB inside the mobile communication device or it can be placed inside the body of the removable memory card or it can be placed on the SIM card or it can be placed on the battery or it can be placed in the combination of these elements.

When using the emitter according to this invention directly on the PCB of the mobile communication device (mainly mobile phone), it is the advantage of the emitter that the emitter used as an antenna has miniature dimensions and can placed wherever on the board or even directly on the chip.

From the technological point of view it will be preferable if the core is created by ferrite rod placed on the non-conductive pad. The non-conductive path will have a width corresponding to the width of the core and its length will basically be identical to the length of the core. The conductors of the threads will be wound through the ferrite rod and also through the non-conductive pad, which means that winding of the conductor mechanically holds together core and the non-conductive pad. The non-conductive pad can have little connecting surfaces for the connection of the conductors of the winding and for connection of the antenna and the carrier, for example PCB. In the connecting surface the conductors of the multi-degree winding are connected together and these contacts of the emitter are connected with the conductive circuits of the host device, too.

### Brief description of drawings

The solution is further disclosed by the figures 1 to 20. The scale of the representation and the ratio of sizes of individual elements do not have to correspond to the description in the examples and these scales and ratios of sizes cannot be interpreted as limiting the scope of protection.

On figure 1 and 2 there is a principle of the increasing lead of the threads of the conductor on the core, whereby with increasing pitch $p_n$ the width w of the conductor remains constant.

Figure 3 is an axonometric view of the emitter with the flat cross-section of the conductor with the increasing gaps. Smaller number of threads is depicted for the purposes of clarity.

Figure 4 is a cross-section of the core with a flat conductor with winding of the flat conductor with the fixed width w. The plane numbered 3 is a longitudal middle plane of the core. The gaps between the conductors are increasing, starting from the middle plane.

Figure 5 depicts a flat conductor with the increasing width w wound onto the core. Figure 6 is then the detail of the increasing pitch $p_n$ and increasing width $w_n$.

Figure 7 is a cross-section of the core with multi-degree winding of the circular conductor where the conductor of all degrees (9 degrees created by 9 conductors) of one thread is the same and isolated. The gap between the threads increases with the increasing lead of the threads; the conductors of one thread are further wound close together.

Figure 8 is a view of the ends of the winding of the emitter at the end of the core with the non-conductive pad which is soldered to the substrate.

Figure 9 is a detail of the connection of the conductors of one thread to the little connecting surface produced on the lower side of the non-conductive pad.

Figure 10 depicts the localization of the emitter on the micro SIM and nano SIM card.

Figures 11 and 12 depict the cross-section of the emitter with examples of dimensions on mini/micro SIM and nano SIM cards.

Figures 13 to 20 explain the bi-metal structure of the conductor by which the permanent grasp of the core by the conductor is achieved, whereby it is not monolithically wound on, but composed of strips. For the purposes of clarity, these figures do not depict the increment in the pitch of the thread; these figures serve only to explain the method of production of the flat winding of the conductor.

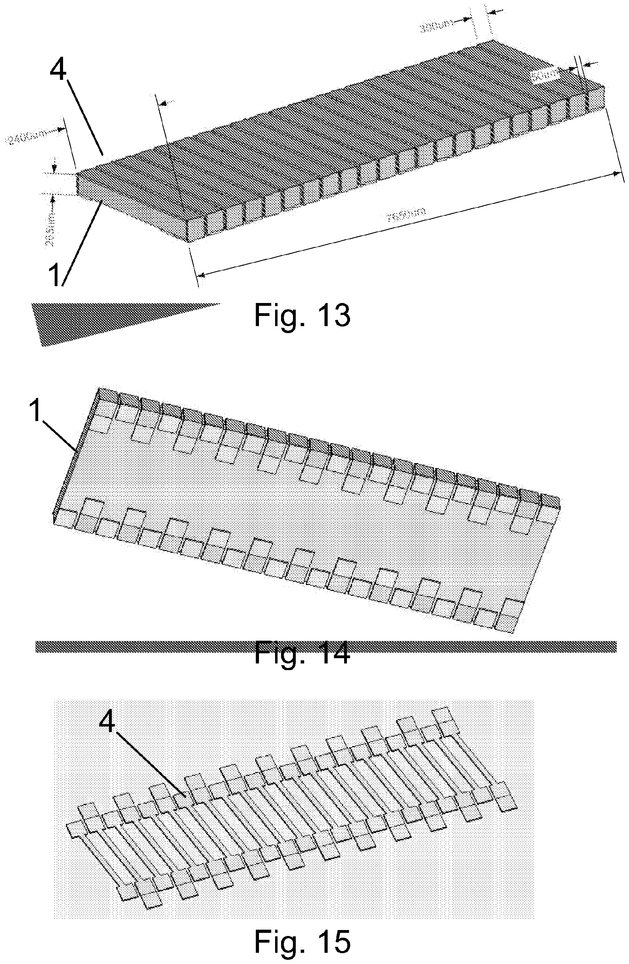

Figure 13 depicts the dimensional example of the flat emitter.

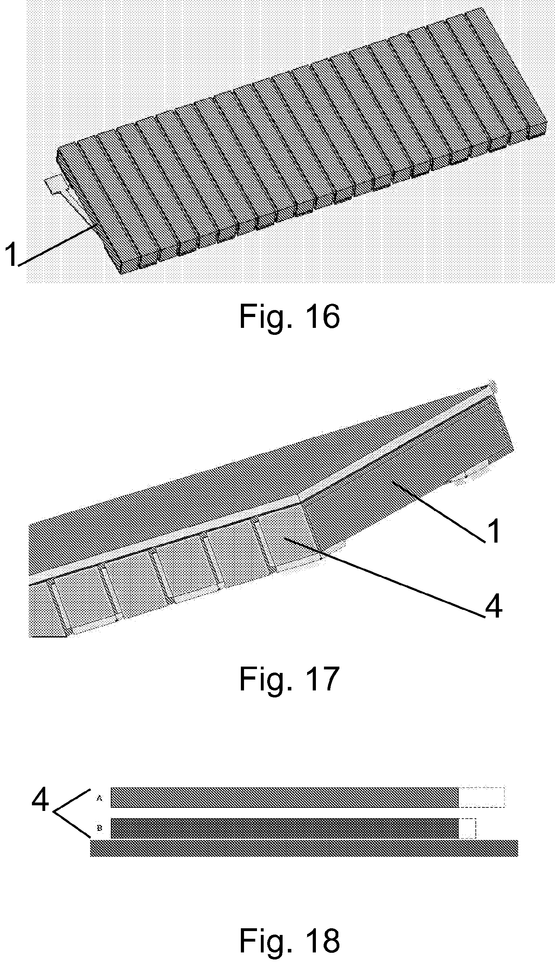

Figure 14 depicts a core wrapped from three edges by the flat conductor before the connection of these conductors into threads. Figure 15 depicts the connecting strips which are then - as depicted on the figure 16 - connected to the bended surfaces of the respective opposing conductors.

Figure 17 depicts a foil which creates a cover on the upper side and at the same time it can carry the distributed strips of the conductors during production.

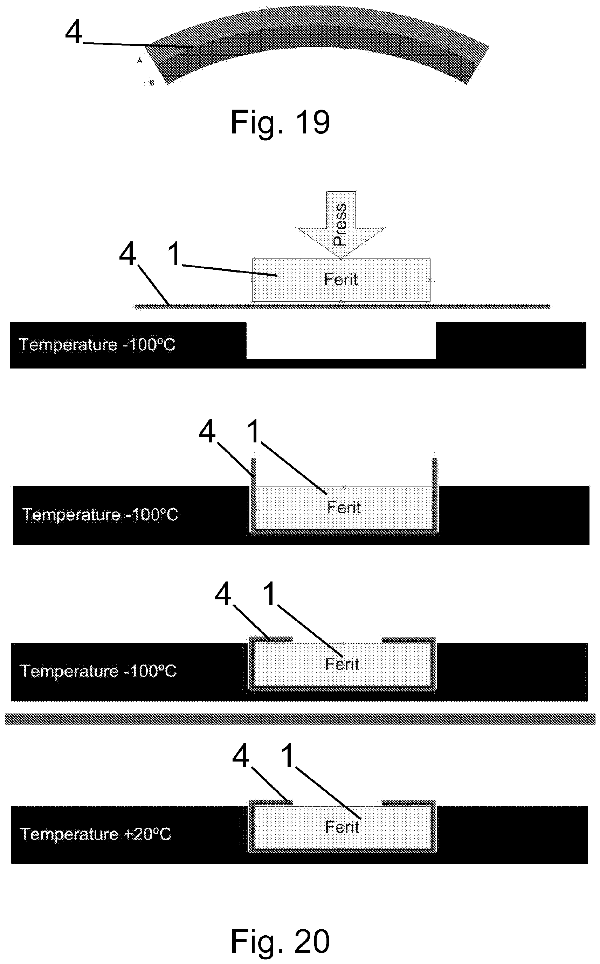

Figure 18 illustrates a bi-metal composition of the conductor with various thermal expansions of the layers. Figure 19 depicts such conductor after the change in temperature.

Figure 20 captures top down the process of the production of the emitter according to this invention, where the bi-metal conductor is winded through the three sides of the cross-section of the core at low temperature and subsequently after warming to the common temperature it reliably wraps the core of the emitter.

## Examples of realization

Example 1

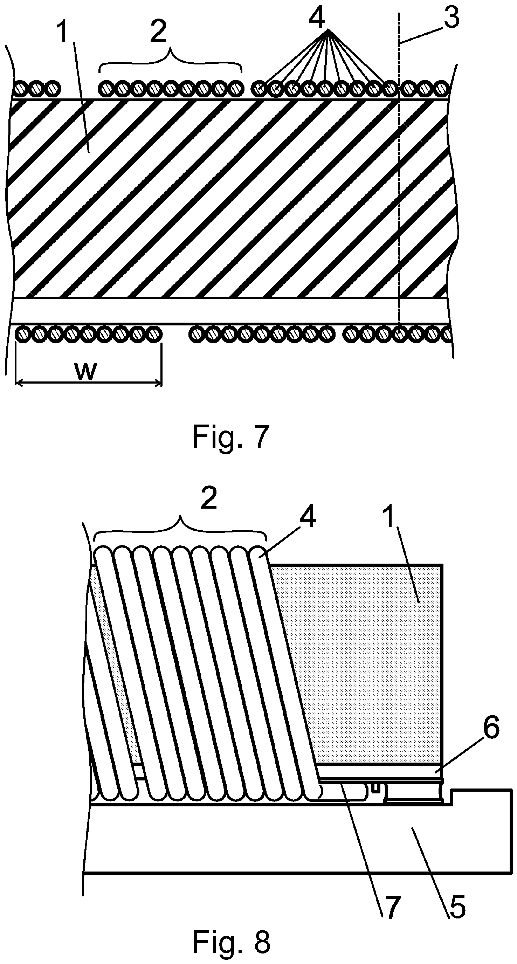

In this example according to figures 7, 8, 9, 10 and 11 a construction of the emitter with the ferrite core 1 of the flat rectangular cross-section is described. The emitter is placed on the micro SIM card. The core 1 is 9 mm long and the rectangular cross-section has dimensions 2,4 mm x 0,3 mm. The non-conductive pad 6 is attached to the core 1, whereby the pad 6 is 2,4 mm wide and 0,4 mm thick. 17 threads 2 from the copper isolated wire are wound on the core 1 and - at the same time - through the non-conductive path 6, whereby the wire is placed in such a way that in the middle zone 3 there are two threads wound tightly close to each other and then the pitch of the thread increases linearly always by +0,065 mm.

One thread 2 is produced by nine conductors 4 with diameter 0,035 mm led in parallel. This is substitute for the flat conductor of one thread 2 of dimensions 0,315 x 0,035 mm.

On the non-conductive pad 6 there are by its ends two little connecting surfaces 7 produced; on these surfaces 7 there are nine mutually conductively connected conductors 41, 42, 43, 44, 45, 46, 47, 48, 49. Conductors 41, 42, 43, 44, 45, 46, 47, 48, 49 are mutually distancing from each other by the ends of the core 1, that is, after the last thread 2, in order to create larger space for the tip of the ultrasonic welding machine. The conductors 41, 42, 43, 44, 45, 46, 47, 48, 49 are soldered or welded by ultrasound to the connecting surfaces 7.

These connecting surfaces 7 are also connected to the contact by which the whole body of the emitter is soldered to the substrate, in this example the substrate of micro SIM card.

The advantage of nine conductors 4 led in parallel in comparison with the flat conductor is the higher conductivity in high frequencies. With regard to skin effect with depth $\rho=17\mu m/14MHz$ the conductive surface of the six circular conductors is $\pi/2$ times more than with the flat conductor with a similar dimensions, which achieves lower losses. Emitter according to this example has a frequency of 14,4 MHz and the inductance L= 1.2 $\mu$H and quality Q=21 with power load 13 dBm.

The material NiZn of the core 1 has following characteristics, which can vary in range $\pm15\%$:

| Symbol | Condition | Value | Unit |
|---|---|---|---|
| $\mu_i$ | 25°C;<10kHz 0.25mT | ~80 | |
| $\mu_a$ | 100°C;<25kHz 200mT | ~300 | |
| $\mu_s'$ | 100°C;<15MHz 200mT | ~80 | |
| $\mu_s''$ | 100°C;<15MHz 200mT | ~5 | |
| B | 25°C;<10kHz 3000A/m | ~320 | mT |
| | 100°C;<10kHz 3000A/m | ~320 | mT |
| Pv | 100°C;<3MHz 100mT | <200 | kWS/m$^3$ |
| | 100°C;<10MHz 5mT | <200 | |
| $\tan\delta/\mu_i$ | 100°C;<15MHz 200A/m | $7,8.10^{-4}$ | |

The antenna system is composed from antenna driver, serial parallel resonation system with the emitter of the magnetic field, and low noise amplifier with high gain (limiter).

Example 2

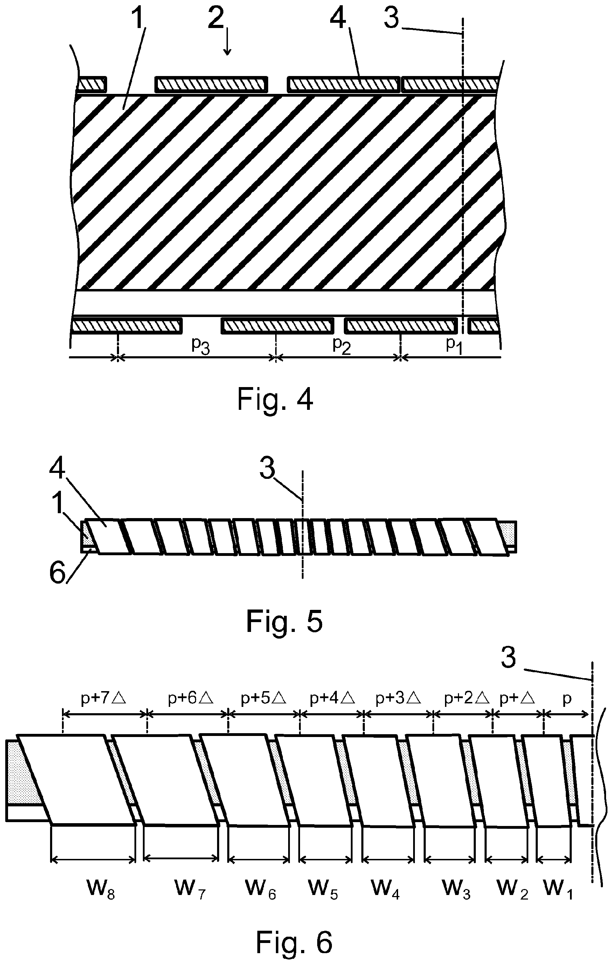

In this example according to figures 5 and 6 the flat isolated conductor 4 is used whose height corresponds to one eighth of the width of the conductor 4 in the cross-section. The flat conductor 4 is shaped in such a way that the line of bending gradually changes the direction of the strip. This allows its winding on the cuboid of the core 1 in such a way that the cross deformations of the strip do not appear. The gap between threads 2 is constant, but the pitch $p_n$ changes; it increases from the middle line 3 towards both ends of the core 1.

Example 3

In this example of realization the conductor 4 is produced on the core 1 by steaming of the metal layer or by similar technology of application of conductive layer on the surface. On the core 1 there is firstly produced a mask functioning as dividing gaps between the threads 2 at least in height of the thickness of the conductor 4. In such case, the mask has a shape of the screw driven strip with the increasing pitch and also increasing angle of the slope against the axis of the core 2. The metal layer is then applied, which produces a flat, wide winding of the conductor 4.

Example 4

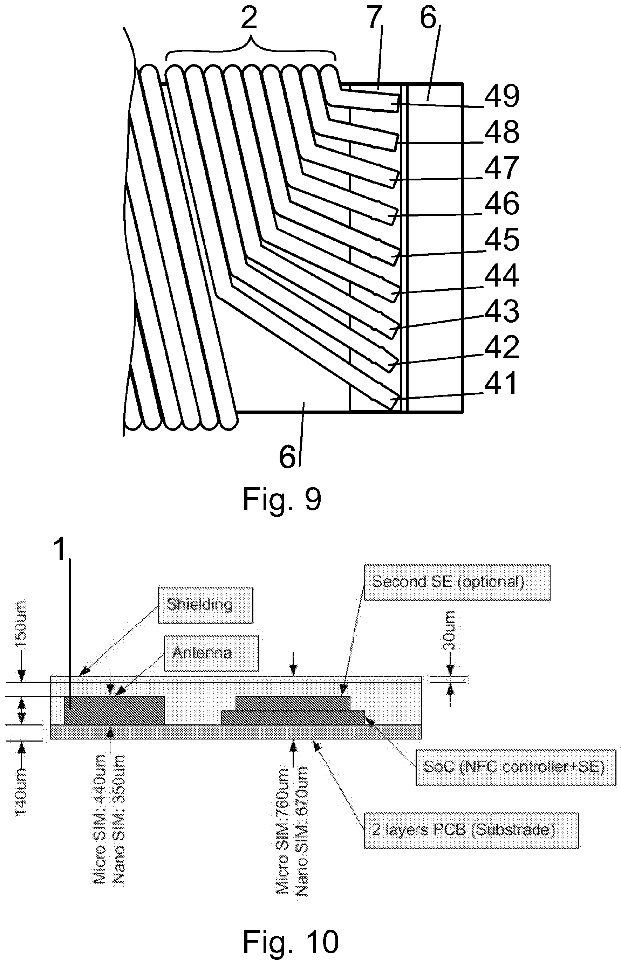

In this example according to figures 10 and 12 the emitter is placed in the nano SIM card. The core 1 has a length 9 mm and a rectangular cross-section with dimensions 2,4 mm x 0,3 mm. Non-conductive pad 6 is attached to the core, which is 2,4 mm wide and 0,04 mm thick. Nine threads 2 from the copper isolated wire are wound through the core 1 and through the non-conductive pad 6, whereby the wire is placed in such a way that in the middle zone 3 there are two threads wound close to each other and then the pitch of the threads increases by 0,065 mm. One thread 2 is produced by nine conductors 4 with diameter 0,035 mm led in parallel to each other.

Example 5

In this example according to figures 13 to 20 the conductor 4 is produced from separated strips which are gradually widening. One thread 2 is formed by two strips. One strip runs through the three sides of the core's cross-section and on the fourth side it has short bent little connecting surfaces. The second strip is a connecting strip and it is on the fourth side of the core's cross-section. The strip of the conductor 4 is produced from two layers as a bi-metal element. The wrapping of the core is realized during low temperatures, for example at -100 °C as depicted in the figure 20. After warming to common temperature 20 °C the conductor 4 has a tendency to tightly wrap the core 1, even if it does not wrap it in the loop of the thread as is coming during winding of the coils.

**Industrial applicability**

Industrial applicability is obvious. According to this invention it is possible to industrially and repeatedly produce and use the non-stationary magnetic field emitters in the function of an antenna with the high emissivity and miniature dimensions.

<div align="center">

**List of related symbols**

</div>

| | |
|---|---|
| 1- core | p - pitch of the threads |
| 2- thread | $p_1$, $p_2$, $p_3$, $p_4$, $p_5$, $p_n$ - pitches of the adjacent threads 1 to n |
| 3- core's middle zone | |
| 4- conductor | w - width of the conductor |
|   41, 42, 43, 44, 45, 46, 47 to 4N - conductors of a single thread | n - number of a thread |
| 5- substrate | m - gap |
| 6- non-conductive pad | |
| 7- connecting surface | PCB - printed circuit board |
| 8- conductor's isolation | NFC - near field communication |
| | RFID - Radio-frequency identification |
| | SD - Secure Digital |
| | SIM - Subscriber Identity Module |

**Claims**

1. A non-stationary magnetic field emitter comprising an at least partially ferrite core (1) and a conductor (4), whereby the conductor (4) with at least three threads (2) is wound on the core (1), and the core has an oblong transverse cross-section, where a width of the cross-section of the core (1) is at least three times more than a height of the cross-section of the core (1) and a length of the core (1) is at least 10 times more that a height of the core (1), the non-stationary magnetic field emitter being **characterized in that** the conductor (4) is wound on the core (1) with a changing distance (p, pitch) between the middles of two adjacent threads (2) of the conductor (4) in such a way that the distance (p, pitch) between the middles of two adjacent threads (2) increases for each following thread (2) from a middle zone (3) of the core (1) towards an end of the core (1).

2. The non-stationary magnetic field emitter according to claim 1 being **characterized in that** an increase of distance (p, pitch) between the middles of two adjacent threads (2) is linear, preferably with the increase ∆ for each following thread (2).

3. The non-stationary magnetic field emitter according to claim 2 being **characterized in that** an increment of the lead ∆ ranges between 10 and 30% of a width of the conductor (4) of the thread (2) in the middle zone (3), preferably 20% of the width of the conductor (4) of the thread (2) in the middle zone (3).

4. The non-stationary magnetic field emitter according to any of the claims 1 to 3 being **characterized in that** the core (1) is 0,5 mm high in the cross-section, preferably up to 0,3 mm, and 2 to 2,5 mm wide in the cross-section.

5. The non-stationary magnetic field emitter according to any of the claims 1 to 4 being **characterized in that** a width w of a single thread (2) in the middle zone (3) is in a range $r_e/2 < w < 1{,}5\ r_e$, where $r_e$ is an equivalent radius, whereby the equivalent radius is a radius of a circular core (1) which has the cross-section's surface identical to a rectangular cross-section of the core (1) with sides a, b.

6. The non-stationary magnetic field emitter according to any of the claims 1 to 5 being **characterized in that** the conductor (4) of a winding is flat, preferably with the width surpassing the double of the height of the conductor (4) in a cross-section; the conductor (4) has in an unwound state a shape of a strip with a changing direction of lines of cranking, which correspond to places of bending around the edge of the core (1).

7. The non-stationary magnetic field emitter according to any of the claims 1 to 5 being **characterized in that** the conductor (4) of the winding is produced by an application of a metal layer onto the surface of the core (1) with gaps between the threads (2).

8. The non-stationary magnetic field emitter according to any of the claims 1 to 7 being **characterized in that** the winding of single thread (2) includes multiple conductors (41 to 4N) led in parallel to each other forming multi-degree thread (2); these conductors (41 to 4N) of single thread (2) are electrically connected, preferably connected alongside the sides of the core (1).

9. The non-stationary magnetic field emitter according to the claim 8 being **characterized in that** the multi-degree conductors (41 to 4N) are at ends of the winding led and connected to connecting surfaces (7) where the conductors (4) are mutually distanced from each other, preferably for at least four multi-degree conductors (41 to 4N) of single thread (2) only outer conductors (41, 4N) of single thread (2) are electrically isolated.

10. The non-stationary magnetic field emitter according to the claim 8 or 9 being **characterized in that** with the increase in the pitch (p) of the threads (2) the conductors (41 to 4N) of single thread (2) begin to diverge, too, and a resulting increasing gap is distributed between all conductors (41 to 4N).

11. The non-stationary magnetic field emitter according to any of the claims 1 to 10 being **characterized in that** the core (1) is created by a ferrite rod placed on a non-conductive pad (6); the non-conductive pad (6) has a width corresponding to the width of the core (1); the non-conductive pad (6) has a length identical to or surpassing the length of the core (1); the conductors (4) of the threads (2) are mechanically wound through the ferrite rod and also through the non-conductive pad (6) so the winding of the conductor (4) connects the core (1) with the non-conductive pad (6); the non-conductive pad (6) has the connecting surfaces (7) by the sides of the core (1) for interconnection of the conductors (4) of the winding and for the interconnectivity of the emitter with a body of a host device.

12. The non-stationary magnetic field emitter according to claim 11 being **characterized in that** the non-conductive pad (6) is from an insulating material with a thickness smaller than one third of the core's (1) height.

13. The non-stationary magnetic field emitter according to any of the claims 1 to 5 being **characterized in that** the conductor (4) is composed of divided strips, whereby at least some of the strips are created by a bi-metal connection of two layers with different thermal expansions and these strips are wrapped around the core (1) at reduced temperature; at working temperature a shear stress keeps the strip in a wrapped position.

14. The non-stationary magnetic field emitter according to any of the claims 1 to 13 being **characterized in that** it is placeable on a substrate (5) of a removable memory card with a contact interface, preferably the removable card is a microSD card or a SIM card or a mini-SIM card or a micro-SIM card or a nano-SIM card.

15. The non-stationary magnetic field emitter according to any of the claims 1 to 14 being **characterized in that** it is placeable on the substrate (5) of a printed circuit board of the host device.

**Patentansprüche**

1. Ein nichtstationäre Magnetfeldemitter, der wenigstens teilweise ferritischen Kern (1) und einen Leiter (4) umfasst, wo es auf dem Kern (1) ein Leiter (4) mit mindestens drei Windungen (2) aufgewickelt ist, und der Kern (1) einen länglichen Querschnitt aufweist, wobei die Breite des Querschnitts des Kerns (1) mindestens dreimal größer als die Höhe des Querschnitts des Kerns (1) ist und die Länge des Kerns (1) mindestens zehnmal größer als die Höhe des Querschnitts des Kerns (1) ist, der nichtstationärer Magnetfeldemitter
**dadurch gekennzeichnet, dass**
der Leiter (4) mit einem sich wandelnden Abstand (p, Steigung) zwischen den Mitten zweier benachbarten Windungen (2) des Leiters (4) auf den Kern (1) aufgewickelt wird, indem der Abstand (p, Steigung) zwischen den Mitten der beiden benachbarten Windungen (2) an jedem nachfolgenden Windung (2) von der Mittelzone (3) des Kerns (1) an in Richtung nach Ende des Kerns (1) erhöht wird.

2. Nichtstationärer Magnetfeldemitter nach Anspruch 1 **dadurch gekennzeichnet, dass** die Zunahme des Abstands (p, Steigung) zwischen den Mitten zweier benachbarter Windungen (2) linear ist, vorteilhaft mit einer Erhöhung des Abstands $\Delta$ für jede nachfolgende Windung (2).

3. Nichtstationärer Magnetfeldemitter nach Anspruch 2 **dadurch gekennzeichnet, dass** das Steigungsinkrement $\Delta$ innerhalb von 10% bis 30% der Breite des Leiters (4) der Windung (2) in der zentralen Zone (3), vorteilhaft 20% der Breite des Leiters (4) der Windung (2) in der Mittelzone (3) beträgt.

4. Nichtstationärer Magnetfeldemitter nach beliebigem Anspruch 1 bis 3 **dadurch gekennzeichnet, dass** der Kern (1) die Querschnittshöhe bis zu 0,5 mm, vorzugsweise bis zu 0,3 mm, und die Breite im Querschnitt von 2 bis 2,5 mm aufweist.

5. Nichtstationärer Magnetfeldemitter nach beliebigem Anspruch 1 bis 4 **dadurch gekennzeichnet, dass** die Breite w einer Windung (2) in der Mittelzone (3) im Bereich $r_e/2 < w < 1,5\ r_e$ liegt, wobei die Größe $r_e$ der äquivalente Durchmesser ist, wo der äquivalente Durchmesser dem Durchmesser des kreisförmigen Kerns (1) mit der gleichen Querschnittsfläche wie der rechteckige Querschnitt des Kerns (1) mit den Seiten a, b entspricht.

6. Nichtstationärer Magnetfeldemitter nach beliebigem Anspruch 1 bis 5 **dadurch gekennzeichnet, dass** der Leiter (4) des Wickels flach ist, vorzüglich mit einer Breite, die die doppelte Höhe des Leiters (4) im Querschnitt überschreitet, der Leiter (4) im gestreckten Zustand eine Streifenform mit einer wechselnden Richtung in den Kröpfungslinien besitzt, die den Positionen von Biegepunkten um die Kante des Kerns (1) herum entsprechen.

7. Nichtstationärer Magnetfeldemitter nach beliebigem Anspruch 1 bis 5 **dadurch gekennzeichnet, dass** der Leiter (4) des Wicklung durch Auftragung einer Metallschicht auf die Oberfläche des Kerns (1) mit Lücken zwischen den Windungen (2) erzeugt wird.

8. Nichtstationärer Magnetfeldemitter nach beliebigem Anspruch 1 bis 7 **dadurch gekennzeichnet, dass** die Aufwicklung einer einzelnen Windung (2) mehrere parallel nebeneinander geführte Leiter (41 bis 4N) enthält, die eine mehrstufige Windung bilden (2), wobei diese Leiter (41 bis 4N) einer einzelnen Windung (2) elektrisch verbunden sind, vorteilhaft an den Seiten des Kerns (1) verbunden sind.

9. Nichtstationärer Magnetfeldemitter nach Anspruch 8 **dadurch gekennzeichnet, dass** die mehrstufig geführten Leiter (41 bis 4N) an den Enden der Wickelung gebracht und mit den Anschlussflächen (7) verbunden sind, wo die Leiter (4) voneinander getrennt sind, vorteilhaft sind bei mehrstufig geführten wenigstens 4 Leitern (41, 4N) einer Windung (2) auf ihrer Oberfläche nur die seitlich liegenden Leiter (41, 4N) einer Windung (2) an ihrer Oberfläche elektrisch isoliert.

10. Nichtstationärer Magnetfeldemitter nach Anspruch 8 oder 9 **dadurch gekennzeichnet, dass** es mit der Zunahme der Steigung (p) der Windungen (2) auch die Leiter (41 bis 4N) eines einzelnen Windung (2) auseinanderzugehen beginnen, wobei die sich vergrößernde Lücke zwischen allen Leitern (41 bis 4N) aufgeteilt wird.

11. Nichtstationärer Magnetfeldemitter nach beliebigem Anspruch 1 bis 10 **dadurch gekennzeichnet, dass** der Kern (1) aus einem Ferritstab besteht, der sich auf einer nichtleitenden Unterlegscheibe (6) befindet, die nichtleitende Unterlegscheibe (6) eine Breite hat, die der Breite des Kerns (1) entspricht, die nichtleitende Unterlegscheibe (6) die gleiche Länge hat oder die Länge des Kerns (1) überschreitet, die Leiter (4) der Windungen (2) sind mechanisch durch den Ferritstab und auch durch die nichtleitende Unterlegscheibe (6) aufgewickelt, wodurch die Wicklung des Leiters (4) den Kern (1) mit der nichtleitenden Unterlegscheibe (6) verbindet, die nichtleitende Unterlegscheibe (6) besitzt an den Seiten des Kerns (1) Verbindungsflächen (7), zur Verbindung der Leiter (4) der Wicklung und um nichtstationärer Magnetfeldemitter mit dem Gehäuse des Hosting-Geräts zu verbinden.

12. Nichtstationärer Magnetfeldemitter nach Anspruch 11 **dadurch gekennzeichnet, dass** die nichtleitende Unterlegscheibe (6) aus dielektrischem Werkstoff mit der Dicke kleiner als ein Drittel der Höhe des Kerns (1) besteht.

13. Nichtstationärer Magnetfeldemitter nach beliebiger Anforderung 1 bis 5 **dadurch gekennzeichnet, dass** die Leiter (4) aus geteilten Streifen zusammengelegt werden, zumindest ein Teil der Streifen wird durch eine Bimetallverbindung aus zwei Schichten mit unterschiedlicher thermischen Ausdehnbarkeit gebildet, diese Streifen werden bei gesenkter Temperatur um den Kern herum umgewunden, wonach der Streifen bei Arbeitstemperatur durch die Verformungsspannung in der umgewundenen Position gehalten wird.

14. Nichtstationärer Magnetfeldemitter nach beliebigem Anspruch 1 bis 13 **dadurch gekennzeichnet, dass** sie auf dem Substrat (5) einer herausnehmbaren Speicherkarte mit Kontaktschnittstelle platziert ist, wobei die herausnehmbare Karte vorzugsweise eine microSD-Karte oder SIM- oder Mini-SIM- oder Micro-SIM- oder Nano-SIM-Karte ist.

15. Nichtstationärer Magnetfeldemitter nach beliebigem Anspruch 1 bis 14 **dadurch gekennzeichnet, dass** sie auf der Substratplatte (5) der Leiterplatte vom Hostgerät platziert ist.

**Revendications**

1. Un émetteur de champ magnétique non stationnaire comprenant au moins en partie un noyau en ferrite (1) et un conducteur (4),
   dans lequel le conducteur (4) comprend d'au moins trois filets (2) est enroulé sur le noyau (1),
   le noyau (1) ayant une section transversale allongée,
   dans lequel une largeur d'une section du noyau (1) est au moins 3 fois supérieure à une hauteur de la section du noyau (1) et une longueur du noyau (1) est au moins 10 fois supérieure à la hauteur de la section du noyau (1),
   émetteur de champ magnétique non stationnaire, **caractérisé en ce que**
   le conducteur (4) est enroulé sur le noyau (1) avec une distance variable (p, pas) entre les centres de deux filets adjacents (2) du conducteur (4) de sorte que la distance (p, pas) entre les centres de deux filets adjacents (2) augmente avec chaque enroulement suivant (2) à partir de la zone centrale (3) du noyau (1) vers les extrémités du noyau (1).

2. Émetteur de champ magnétique non stationnaire selon la revendication 1, **caractérisé en ce qu'**une augmentation de la distance (p, pas) entre les centres de deux filets adjacents (2) est linéaire, de préférence avec augmentation de l'écartement Δ par chaque filet suivant (2).

3. Émetteur de champ magnétique non stationnaire selon la revendication 2, **caractérisé en ce qu'**une augmentation de pas Δ est entre 10 à 30% de largeur du conducteur (4) du filet (2) dans la zone centrale (3), de préférence 20% de la largeur du conducteur (4) du filet (2) dans la zone centrale (3).

4. Émetteur de champ magnétique non stationnaire selon l'une quelconque des revendications 1 à 3, **caractérisé en ce que** la hauteur du noyau (1) en coupe transversale est de 0,5 mm au maximum, de préférence à 0,3 mm, est sa largeur en coupe est de 2 à 2,5 mm.

5. Émetteur de champ magnétique non stationnaire selon l'une quelconque des revendications 1 à 4, **caractérisé en ce que** la largeur w d'un filet (2) dans la zone centrale (3) est de $r_e/2 < w < 1,5\ r_e$, où $r_e$ est un diamètre équivalent, ce diamètre équivalent caractérise le diamètre du noyau circulaire (1) ayant l'aire de section transversale équivalente à celle que la section rectangulaire du noyau (1) avec les côtés a, b.

6. Émetteur de champ magnétique non stationnaire selon l'une quelconque des revendications 1 à 5, **caractérisé en ce** le conducteur (4) enroulé est plat, de préférence de largeur dépassant le double de la hauteur du conducteur (4) en section, le conducteur (4) étant en forme de bande à l'état déplié, variant en direction dans les lignes de pliage correspondant aux points de pliage autour du bord du noyau (1).

7. Émetteur de champ magnétique non stationnaire selon l'une quelconque des revendications 1 à 5, **caractérisé en ce** le conducteur (4) enroulé est formé en appliquant une couche métallique sur la surface du noyau (1) avec des espaces entre les filets (2).

8. Émetteur de champ magnétique non stationnaire selon l'une quelconque des revendications 1 à 7, **caractérisé en ce** l'enroulement d'un filet (2) implique plusieurs conducteurs quidés côte à côte (41 à 4N) formant un filet à plusieurs étages (2), ces conducteurs (41 à 4N) d'un filet (2) étant interconnectés électriquement, de préférence étant interconnectés sur les côtés du noyau (1).

9. Émetteur de champ magnétique non stationnaire selon la revendication 8, **caractérisé en ce que** les conducteurs guidés à plusieurs niveaux (41 à 4N) sont aux extrémités de l'enroulement amenés et connectés à des surfaces de connexion (7), où les conducteurs 4 sont espacés l'un à l'autre, de préférence seulement les conducteurs d'extrémité (41, 4N) d'un filet (2), parmi les 4 conducteurs (41 à 4N) guidés à plusieurs niveaux, sont isolés électriquement sur leurs surfaces.

10. Émetteur de champ magnétique non stationnaire selon la revendication 8 ou 9, **caract érisé en ce que** les conducteurs (41 à 4N) d'un filet (2) commencent également à s'écarter au fur et à mesure que le pas (p) des filets (2) augmente, une fente formée élargissant étant répartie entre tous les conducteurs (41 à 4N).

11. Émetteur de champ magnétique non stationnaire selon l'une quelconque des revendications 1 à 10, **caractérisé en ce** le noyau (1) est formé par une tige en ferrite placée sur un appui non conductrice (6), l'appui non conductrice (6) ayant une largeur correspondant à la largeur du noyau (1), l'appui non conductrice (6) ayant une longueur égale ou supérieure à la longueur du noyau (1), les conducteurs (4) des filets (2) sont enroulés mécaniquement à travers la tige en ferrite et également à travers de l'appui non conductrice (6), ainsi l'enroulement du conducteur (4) connecte le noyau (1) au l'appui non conductrice (6), l'appui non conductrice (6) ayant des plots de connexion (7) sur les côtés du noyau (1) pour interconnecter les conducteurs (4) de l'enroulement et pour interconnecter l'émetteur au corps de l'appareil hôte.

12. Émetteur de champ magnétique non stationnaire selon la revendication 11, **caractérisé en ce que** l'appui non conductrice (6) est en matériau diélectrique d'une épaisseur inférieure à un tiers de la hauteur du noyau (1).

13. Émetteur de champ magnétique non-stationnaire selon l'une quelconque des revendications 1 à 5, **caractérisé en ce** les conducteurs (4) sont composés de petites bandes divisées, au moins une partie de ces bandes étant formée d'une liaison bimétallique de deux couches avec des dilatations thermiques différentes et ces bandes sont enroulées autour du noyau à une température abaissée, la contrainte de déformation à la température de fonctionnement maintient la bande en position enroulée.

14. Émetteur de champ magnétique non stationnaire selon l'une quelconque des revendications 1 à 13, **caractérisé en ce qu**'il est placé sur un substrat (5) d'une carte mémoire amovible avc interface de contact, la carte amovible étant de préférence une carte microSD ou SIM ou mini-SIM ou micro-SIM ou nano-carte SIM.

15. Émetteur de champ magnétique non stationnaire selon l'une quelconque des revendications 1 à 14, **caractérisé en ce qu**'il est placé sur un substrat (5) d'un circuit imprimé de l'appareil hôte.

Fig. 1

Fig. 2

Fig. 3

EP 3 216 082 B1

Fig. 4

Fig. 5

Fig. 6

Fig. 7

Fig. 8

Fig. 9

Fig. 10

Mini/micro SIM

Ferrite core

2400um

4

1

256um

310um

440um

54um

Winding

Air gap

6

## Fig. 11

Nano SIM

4

2400um

1

166um

260um

350um

54um

6

## Fig. 12

Fig. 13

Fig. 14

Fig. 15

Fig. 16

Fig. 17

Fig. 18

4

Fig. 19

4    1

Press

Ferit

Temperature -100°C

4    1

Ferit

Temperature -100°C

4    1

Ferit

Temperature -100°C

4    1

Ferit

Temperature +20°C

Fig. 20

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102008005795
- KR 100693204
- WO 2010143849 A
- JP 2004005494 B
- JP 2006304184 B
- JP 2005033461 B
- JP 2010051012 B
- CN 201590480 U
- US 2011241957 A1
- WO 2014076669 A